# EUROPÄISCHE PATENTANMELDUNG

(11) **EP 2 469 293 A2**
(43) Veröffentlichungstag der Anmeldung: **27.06.2012**
(21) Anmeldenummer: 11186200.9
(22) Anmeldetag: 21.10.2011
(51) Int. Cl.: G01S 7/03, G01S 13/93, G01R 31/04, G01R 31/02

(54) **Degradationsbestimmung einer elektrischen Verbindung**

(30) Priorität: 21.12.2010 DE 102010063761
(71) Anmelder: Robert Bosch GmbH, 70442 Stuttgart (DE)
(72) Erfinder: Himmelstoss, Armin, 71554 Weissach Im Tal (DE); Heintze, Andreas, 71032 Boeblingen (DE)

(57) **Zusammenfassung**

Ein elektrisches Gerät umfasst Anschlüsse für eine elektrischen Verbindung zu einer Spannungsquelle, eine Abtasteinrichtung zur Bestimmung einer an den Anschlüssen anliegenden Spannung, eine steuerbare Last zur Veränderung einer elektrischen Leistungsaufnahme des Geräts an den Anschlüssen und eine Steuereinrichtung, die dazu eingerichtet ist, eine Degradation der elektrischen Verbindung zu bestimmen, falls bei unterschiedlichen elektrischen Leistungsaufnahmen an den Anschlüssen anliegende Spannungen sich um mehr als ein vorbestimmtes Maß voneinander unterscheiden.

## Beschreibung

Die Erfindung betrifft ein elektrisches Gerät und ein Verfahren zur Erfassung einer Degradation einer elektrischen Verbindung zwischen dem Gerät und einer Spannungsquelle mit den Merkmalen der Ansprüche 1 bzw. 6. Unteransprüche geben bevorzugte Ausführungsformen wieder.

### Stand der Technik

In Systemen von mehreren miteinander verbundenen elektrischen Geräten sind elektrische Verbindungen zwischen den Geräten häufig Belastungen ausgesetzt, die eine Leitungsqualtiät der elektrischen Verbindungen vermindern können. Beispielsweise kann eine elektrische Verbindung zwischen zwei Steuergeräten an einem Kraftfahrzeug mechanischen, thermischen und chemischen Belastungen ausgesetzt sein. Diese Belastungen können dazu führen, dass eines der Geräte nur noch fehlerhaft funktioniert. Häufig ist nicht eindeutig reproduzierbar, unter welchen Umständen ein Fehler auftritt, so dass im Fehlerfall aus Sicherheitsgründen oft mehr Elemente erneuert werden, als eigentlich nötig wäre.

Es ist bekannt, miteinander vernetzte elektrische Geräte an Bord eines Kraftfahrzeugs mit Diagnosefunktionen auszustatten, so dass Fehler an einer der elektrischen Komponenten an einer zentralen Stelle gesammelt und ausgewertet werden können. Beispielsweise können ein Fahrer des Kraftfahrzeugs vom Vorliegen des Fehlers informiert und Umstände des Fehlers in einem Fehlerspeicher abgelegt werden, um die Ursache des Fehlers in einer Werkstatt genauer lokalisieren zu können.

DE 10 2005 046 282 A1 zeigt eine Vorrichtung zur Fehlerstromerkennung in einem elektronischen Gerät, wobei eine ihren Zweck nur mangelhaft erfüllende Isolation eines Leiters erfasst wird, wenn ein Strom zwischen dem Leiter und einem weiteren Leiter im Bereich der Isolation fließt.

Allgemein ist es wünschenswert, einen Fehler bereits vor bzw. während seiner Entstehung zu bestimmen, um ihn beheben zu können, bevor die Ursache für den Fehler weitere Fehler nach sich zieht. Es ist daher Aufgabe der Erfindung, ein elektrisches Gerät anzugeben, das dazu eingerichtet ist, eine Degradation einer elektrischen Verbindung eines elektrischen Geräts mit einer Spannungsquelle zu bestimmen. Es ist eine weitere Aufgabe der Erfindung, ein Verfahren zur Bestimmung der Degradation der elektrischen Verbindung anzugeben.

Die Erfindung löst diese Aufgaben mittels eines Geräts mit den Merkmalen von Anspruch 1 und eines Verfahrens mit den Merkmalen von Anspruch 6. Anspruch 10 gibt ein Computerprogrammprodukt an. Unteransprüche betreffen bevorzugte Ausführungsformen der Erfindung.

### Offenbarung der Erfindung

Nach einem ersten Aspekt betrifft die Erfindung ein elektrisches Gerät mit Anschlüssen für eine elektrische Verbindung zu einer Spannungsquelle, eine Abtasteinrichtung zur Bestimmung einer an den Anschlüssen anliegenden Spannung, einer steuerbaren Last zur Veränderung einer elektrischen Leistungsaufnahme des Geräts an den Anschlüssen und eine Steuereinrichtung, die dazu eingerichtet ist, eine Degradation der elektrischen Verbindung zu bestimmen, falls bei unterschiedlichen elektrischen Leistungsaufnahmen an den Anschlüssen anliegende Spannungen sich um mehr als ein vorbestimmtes Maß voneinander unterscheiden.

Vorteilhafterweise kann die Bestimmung, ob eine Degradation der elektrischen Verbindung vorliegt, zu einem Zeitpunkt vorgenommen werden, zu dem eine Fehlfunktion des elektrischen Geräts noch nicht stattgefunden hat. Insbesondere eine schleichende Degradation der elektrischen Verbindung kann durch das Gerät rechtzeitig festgestellt werden.

Die elektrische Verbindung kann eine Steckverbindung umfassen und die Degradation kann eine Korrosion der Steckverbindung sein. Insbesondere im Kraftfahrzeug-Umfeld sind Steckverbindungen aus Gründen der Montage und Wartung weit verbreitet. Eine Korrosion der Steckverbindung kann durch Vibrationen, Benzin, Öl, Salz, Hitze, Kälte und Feuchtigkeit mehr oder weniger schleichend voranschreiten.

Die elektrische Verbindung kann auch ein elektromechanisches Unterbrechungselement umfassen und die Degradation kann einen Verschleiß des Unterbrechungselements umfassen. Beispielsweise kann ein mechanisch betätigter Schalter einem Kontaktabbrand unterliegen. Dabei können sich Oxidschichten und andere Verunreinigungen am Schalter bilden, die einen Stromfluss durch den Schalter behindern. Durch den Kontaktabbrand können die Kontakte des Schalters auch soweit deformiert werden, dass der Schalter nicht mehr vollständig öffnet oder schließt. Das Unterbrechungselement kann in entsprechender Weise auch ein Kommutator, etwa eines Generators oder eines Elektromotors, sein.

Bevorzugterweise umfasst die steuerbare Last einen schaltbaren elektrischen Widerstand. Dadurch kann auf kostengünstige Weise die Leistungsaufnahme des Geräts auf einen vorbestimmten Wert gesteuert werden, so dass vorbestimmte Leistungsaufnahmen an den Anschlüssen des Geräts generierbar sind. Der elektrische Widerstand kann in dem Gerät verbaut oder, etwa zur Ableitung von entstehender Wärme im Bereich des Widerstands, außerhalb des Geräts angeordnet sein.

Bevorzugterweise umfasst die steuerbare Last ein Funktionselement des Geräts, das ohnehin vorhanden ist und bedarfsgesteuert ein- bzw. ausschaltbar ist. Insbesondere kann das Gerät ein Radarsensor zur Verwendung an einem Kraftfahrzeug sein und der elektrische Widerstand kann eine elektrische Heizung einer heizbaren Radarlinse des Radarsensor umfassen. So kann ein bestehender Radarsensor mit relativ geringen Änderungen erfindungsgemäß verwendet werden, wodurch ein Entwurfs- und Herstellungsaufwand für das Gerät reduziert sein können.

Nach einem zweiten Aspekt betrifft die Erfindung ein Verfahren zur Erfassung einer Degradation einer elektrischen Verbindung zwischen einer Spannungsquelle und Anschlüssen eines elektrischen Geräts. Dabei umfasst das Verfahren Schritte des Bestimmens einer ersten Spannung, die an den Anschlüssen des elektrischen Geräts anliegt, des Veränderns einer elektrischen Leistungsaufnahme des Geräts an den Anschlüssen, des Bestimmens einer zweiten Spannung, die an den Anschlüssen des elektrischen Geräts anliegt, und des Bestimmens der Degradation, falls sich die Spannungen um mehr als ein vorbestimmtes Maß voneinander unterscheiden.

Vorteilhafterweise lässt sich das beschriebene Verfahren mit geringem Aufwand an einer Vielfalt von elektrischen Geräten einsetzten, die die Vorraussetzungen bieten, das Verfahren auszuführen. Dies trifft insbesondere für elektrische Steuergeräte zu, die mittels eines integrierten programmierbaren Mikrocomputers steuerbar sind.

Bevorzugterweise werden die Spannungen in eine digitale Form umgewandelt und in der digitalen Form miteinander verglichen. Dadurch kann eine aufwendige analoge Speicherung der ersten Spannung, bis die zweite Spannung für den Vergleich vorliegt, vermieden werden. Darüber hinaus kann die weitere Verarbeitung der beiden Spannungen in ihren digitalen Formen schneller und genauer sein.

Das beschriebene Verfahren kann durch unterschiedliche Vorgänge ausgelöst werden. Beispielsweise kann das Verfahren durchgeführt werden, nachdem von einem mit dem Gerät verbindbaren Steuergerät ein das Verfahren auslösendes Signal empfangen wurde. Alternativ oder zusätzlich kann das Verfahren zeitgesteuert ausgeführt werden, also beispielsweise in festen zeitlichen Intervallen während einer Betriebsdauer des Geräts. Weiter zusätzlich oder alternativ kann das Verfahren ereignisgesteuert ausgelöst werden, beispielsweise immer dann, wenn das Gerät in Betrieb genommen wird. Kombinationen sind ebenfalls möglich, beispielsweise eine Auslösung nach einer vorbestimmten Zeit nach einem vorbestimmten Ereignis.

Bevorzugterweise umfasst das Verfahren einen abschließenden Schritt des Ausgebens eines auf die Degradation hinweisenden Signals an ein weiteres Steuergerät. Dieses Steuergerät kann mit dem Steuergerät, welches das Signal zum Durchführen des Verfahrens ausgesandt hat, identisch sein. Durch das Ausgeben des auf die Degradation hinweisenden Signals wird eine zentrale Fehlerbehandlung ermöglicht. Dadurch kann beispielsweise eine bestimmte Degradation der elektrischen Verbindung mit einem anderen Ereignis, beispielsweise einer Degradation einer weiteren elektrischen Verbindung, korreliert werden, so dass mit verbesserter Genauigkeit angegeben werden kann, an welcher Stelle der elektrischen Verbindung die Degradation auftritt.

Nach einem dritten Aspekt betrifft die Erfindung ein Computerprogrammprodukt mit Programmcodemitteln zur Durchführung des angegebenen Verfahrens, wenn es auf einer Verarbeitungseinrichtung abläuft oder auf einem computerlesbaren Datenträger abgespeichert ist.

### Kurze Beschreibung der Figuren

Im Folgenden wird die Erfindung mit Bezug auf die beigefügten Figuren genauer beschrieben, in denen:
- Figur 1: ein elektrisches Gerät an Bord eines Kraftfahrzeugs; und
- Figur 2: ein Ablaufdiagramm eines Verfahrens im Gerät aus Figur 1 darstellt.

### Genaue Beschreibung von Ausführungsformen

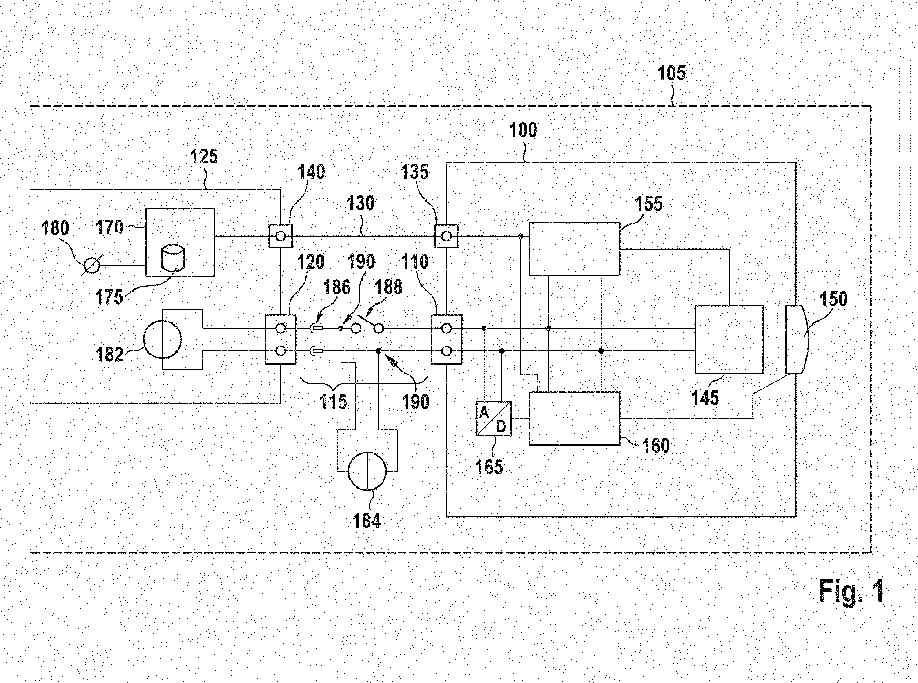

Figur 1 zeigt ein schematisches Diagramm eines elektrischen Geräts 100 an Bord eines Kraftfahrzeugs 105. In der Darstellung von Figur 1 ist das Gerät 100 ein Radarsensor zur Bestimmung eines Abstandes zu einem Formkraftfahrzeug 105 entfernten Objekt.

In alternativen Ausführungsformen kann das Gerät 100 jedoch auch ein anderes Gerät, insbesondere ein Steuergerät, ein Sensor oder ein elektrischer Aktor sein. Das Gerät kann an Bord des Kraftfahrzeugs 105 oder in einem Flugzeug, Luft-oder Raumschiff, einem Baufahrzeug, einer Baumaschine, einem Schienenfahrzeug, einer Anlage der Automatisierungstechnik, einem Leitstand, in der Kraftwerkstechnik, in einer Überwachungs- oder sicherheitsrelevanten elektrischen

Anlage eines Atomkraftwerks oder einer Forschungseinrichtung, an einem Militärfahrzeug oder einer militärischen Einrichtung eingesetzt werden. Wie im Folgenden ausgeführt wird, sind mit dem elektrischen Gerät 100 neben allgemeinen Steckverbindungen, Leitungen und Massepunkten, die aufgrund von Korrosion und/oder mechanischer Degradation erhöhte Übergangswiderstände entwickeln können, auch beispielsweise Schalter, Relais, Kommutatoren, häufig gesteckte Steckverbinder oder Einschubsysteme mit Backplane-Steckverbindern auf eine Bildung unerwünschter erhöhter Übergangswiderstände hin überwachbar.

Das Gerät 100 umfasst ein Paar Anschlüsse 100, die mittels einer elektrischen Verbindung 115 mit einem Paar Anschlüssen 120 eines Steuergeräts 125 verbunden sind. Ferner besteht eine Kommunikationsverbindung 130 zwischen einem Anschluss 135 des Geräts 100 und einem Anschluss 140 des Steuergeräts 125.

Das Gerät 100 umfasst einen Radarsensor 145, eine heizbare Radarlinse 150, eine Sensorsteuerung 155, eine Steuereinrichtung 160 und einen Analog-Digital-Wandler 165.

Die Anschlüsse 110 des Geräts 100 sind intern elektrisch mit dem Radarsensor 145, der Sensorsteuerung 155, Steuereinrichtung 160 und dem Analog-Digital-Wandler 165 verbunden. Ferner ist der Anschluss 135 für die Kommunikationsverbindung 130 innerhalb des Geräts 100 mit der Sensorsteuerung 155 und der Steuereinrichtung 160 verbunden. Die Steuereinrichtung 160 ist außerdem mit der heizbaren Radarlinse 150 und dem Analog-Digital-Wandler 165 verbunden. Eine weitere Verbindung besteht zwischen dem Radarsensor 145 und der Sensorsteuerung 155.

Das Steuergerät 125 kann eine mit dem Anschluss 140 für die Kommunikationsverbindung 130 verbundene Verarbeitungseinrichtung 170 umfassen. Die Verarbeitungseinrichtung 170 kann ferner einen Fehlerspeicher 175 umfassen. Außerdem kann die Verarbeitungseinrichtung 170 mit einer Schnittstelle 180 verbunden sein, um ein Signal an einen Fahrer des Kraftfahrzeugs 105 oder eine weitere Steuerkomponente auszugeben. Ferner kann das Steuergerät 125 eine erste Spannungsquelle 182 umfassen, die mit den Anschlüssen 120 für die elektrische Verbindung 115 verbunden ist. In einer alternativen Ausführungsform kann eine Spannungsversorgung des Steuergeräts 125 und des Geräts 100 mittels einer zweiten Spannungsquelle 184 erfolgen, die zwischen den Anschlüssen 110 und 120 mit der elektrischen Verbindung 115 verbunden ist.

Die elektrische Verbindung 115 kann eine Steckverbindung 186 umfassen. Die Steckverbindung 186 kann die Anschlüsse 120 des Steuergeräts 125 oder die Anschlüsse 110 des Geräts 100 umfassen. Ferner kann ein Schalter 188 zum Unterbrechen der elektrischen Verbindung 115 vorgesehen sein. Im Fall der Verwendung der zweiten Spannungsquelle 184 können Kontaktpunkte 190 bestehen, wo die zweite Spannungsquelle 184 mit der elektrischen Verbindung 115 verbunden ist.

Ist der Schalter 188 geschlossen, so liegt an den Anschlüssen 110 üblicherweise eine Spannung an, die der Spannung der ersten Spannungsquelle 182 oder der Spannung der zweiten Spannungsquelle 184 entspricht. Insbesondere elektrische Übergänge der elektrischen Verbindung 115, nämlich die Anschlüsse 110 und 120, die Steckverbindungen 186, der Schalter 188 und die Kontaktpunkte 190, bieten Angriffsflächen für Verschmutzung, Verschleiß und Korrosion. Derartige Einflüsse können sich mechanisch auf die elektrische Verbindung 115 auswirken und ein elektrischer Widerstand zwischen der Stromquelle 182 bzw. 184 und den Anschlüssen 110 des Geräts 100 kann ansteigen.

Solange eine Leistungsaufnahme des Geräts 100 relativ gering ist, ist die an den Anschlüssen 110 des Geräts 100 anliegende Spannung dann nur um einen geringen Betrag kleiner als die Spannung der ersten Spannungsquelle 182 bzw. der zweiten Spannungsquelle 184. Steigt jedoch die Leistungsaufnahme des Geräts 100 an, beispielsweise weil eine interne Komponente des Geräts 100 aktiviert wird, so kann aufgrund des Widerstands der elektrischen Verbindung 115 die an den Anschlüssen 110 anliegende Spannung einbrechen und signifikant unterhalb der von der Stromquelle 182 bzw. 184 bereitgestellte Spannung liegen. Eine ordnungsgemäße Funktion des Geräts 100 kann dann nicht mehr gewährleistet sein.

Um zu bestimmen, ob eine Degradation der elektrischen Verbindung 115 vorliegt, ist die Steuereinrichtung 160 dazu eingerichtet, mittels des Analog-Digital-Wandlers 165 die an den Anschlüssen 110 des Geräts 100 anliegende Spannung unter zwei unterschiedlichen Leistungsaufnahmen des Geräts 100 zu bestimmen. Eine Veränderung der Leistungsaufnahme 100 wird durch Aktivieren eines elektrischen Verbrauchers in Form der heizbaren Radarlinse 150 im Gerät 100 herbeigeführt. In einer alternativen Ausführungsform kann die Steuereinrichtung 160 auch ein Abschalten einer Komponente des Geräts 100 bewirken, um die Veränderung der Leistungsaufnahme des Geräts 100 im Form einer Verringerung der aufgenommenen Leistung herbeizuführen.

Die mittels des Analog-Digital-Wandlers 165 bei unterschiedlichen Leistungsaufnahmen des Geräts 100 abgetasteten und mittels des Analog-Digital-Wandlers 165 digitalisierten Spannungen werden durch die Steuereinrichtung 160 numerisch miteinander verglichen. Übersteigt der Unterschied zwischen den bestimmten Spannungen ein vorbestimmtes Maß, so ist die Steuereinrichtung 160 dazu eingerichtet, eine Degradation der elektrischen Verbindung 115 zu bestimmen. In diesem Fall kann ein Bestimmungsergebnis mittels der Kommunikationsverbindung 130 von der Steuereinrichtung 160 des Geräts 100 an das Steuergerät 125 übermittelt werden.

In einer Ausführungsform fallen die Sensorsteuerung 155 und die Steuereinrichtung 160 zusammen. In einer anderen Ausführungsform erfolgt eine Übermittlung der durch den Analog-Digital-Wandler 165 abgetasteten Spannungen mittels der Kommunikationsverbindung 130 zur Verarbeitungseinrichtung 170 des Steuergeräts 125. Der numerische Vergleich der Spannungen und die Bestimmung, ob ein Unterschied zwischen den beiden Spannungen das vorbestimmte Maß übersteigt, wird dann durch die Verarbeitungseinrichtung 170 durchgeführt.

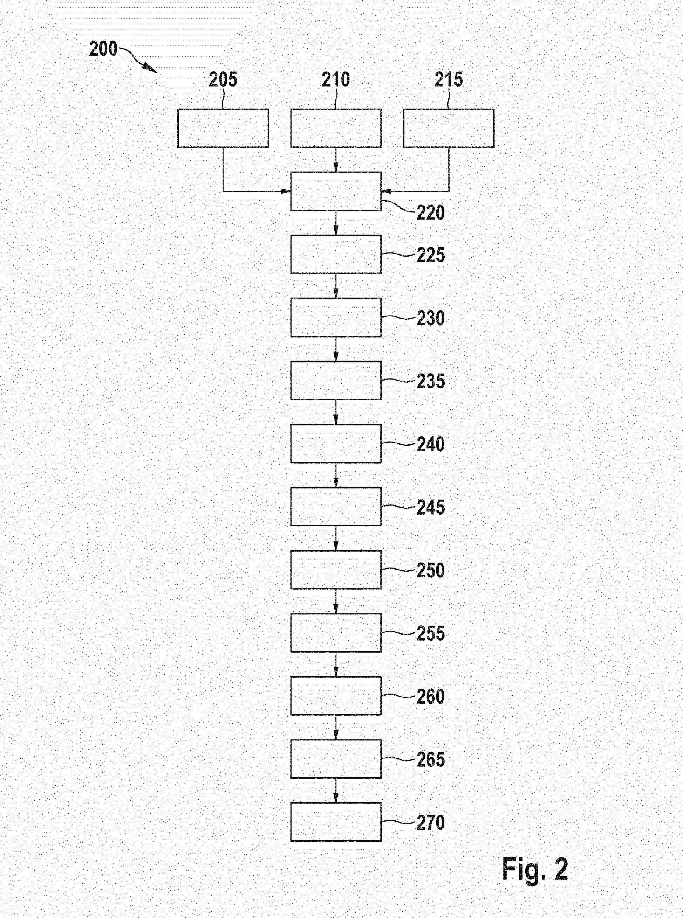

Figur 2 zeigt ein Ablaufdiagramm eines Verfahrens 200 zur Bestimmung der Degradation der elektrischen Verbindung 115 in Figur 1. Vorzugsweise wird das Verfahren 200 auf der Steuereinrichtung 160 des Geräts 100 durchgeführt, wobei weiter vorzugsweise die Verarbeitungseinrichtung 160 ein programmierbarer Mikrocomputer ist.

Das Verfahren 200 kann durch einen der Schritte 205, 210 oder 215 eingeleitet werden. Im Schritt 205 fordert das Steuergerät 125 mittels der Kommunikationsverbindung 130 das Überprüfen der elektrischen Verbindung 115 auf Degradation durch das Gerät 100 an. Im Schritt 210 wird die Überprüfung seitens des Geräts 100 auf der Basis einer zeitlichen Bestimmung initiiert. Die Überprüfung kann beispielsweise periodisch in festen Intervallen durchgeführt werden. Im Schritt 215 wird die Überprüfung seitens des Geräts 100 ereignisbassiert angestoßen. Ein solches Ereignis kann die Inbetriebnahme des Geräts 100 umfassen. Dabei ist die Inbetriebnahme üblicherweise dadurch bestimmbar, dass das Gerät 100 über die Anschlüsse 110 mit einer elektrischen Spannung versorgt wird.

Die Schritte 205, 210, 215 bedingen sich gegenseitig nicht; die verfahrensgemäß folgende Bestimmungder Degradation kann auf eine beliebige der drei beschriebenen Weisen oder auch eine Kombination daraus begonnen werden.

In einem Schritt 220 wird eine erste Spannung an den Anschlüssen 110 des Geräts 100 bestimmt. Anschließend wird die erste Spannung in einem Schritt 225 in einen digitalen Wert umgewandelt und in einem Schritt 230 in digitaler Form abgespeichert. Einige oder alle der Schritte 220 bis 230 können in einer Ausführungsform der Erfindung auch stattfinden, bevor einer der eröffnenden Schritte 205, 210 oder 215 durchgeführt wurde.

In einem Schritt 235 wird die Leistungsaufnahme des Geräts 100 verändert. Dazu wird üblicherweise ein Funktionsteil des Geräts 100, welches zunächst außer Funktion ist, in Funktion genommen, oder, in einer alternativen Ausführungsform, ein in Funktion stehendes Element des Geräts 100 außer Funktion genommen. Die Veränderung der Leistungsaufnahme kann auch durch eine Änderung der Beanspruchung eines Elements des Geräts 100 hergestellt werden. Beispielsweise kann ein digitaler Mikroprozessor zur Erhöhung der Leistungsaufnahme gezielt beschäftigt werden oder zur Verringerung der Leistungsaufnahme von Beschäftigungen freigestellt werden.

In einem folgenden Schritt 240 wird eine zweite Spannung an den Anschlüssen 110 des Geräts 100 bestimmt. Vorzugsweise wird unmittelbar nach dem Bestimmen der zweiten Spannung in einem Schritt 245 die Änderung der Leistungsaufnahme aus Schritt 235 wieder rückgängig gemacht, um einen normale Betrieb des Geräts 100 nicht länger als nötig zu beeinflussen. Das Zurückändern im Schritt 245 kann auch zu einem beliebigen späteren Zeitpunkt erfolgen.

Die zweite Spannung wird in einem Schritt 250 mittels des Analog-Digital-Wandlers 165 in einen digitalen Wert überführt und in einem Schritt 255 in digitaler Form abgespeichert. Der Schritt 255 kann entbehrlich sein, wenn die zweite Spannung nicht weiter verarbeitet wird. In einem Schritt 260 wird eine Differenz zwischen den digitalen Werten der ersten und der zweiten Spannung bestimmt. Anschließend wird die Differenz in einem Schritt 256 mit einem vorbestimmten Maß verglichen. Das vorbestimmte Maß ist vorzugsweise innerhalb der Steuereinrichtung 160 bzw. der Verarbeitungseinrichtung 170 fest abgelegt. In einer alternativen Ausführungsform kann das vorbestimmte Maß auch algorithmisch bestimmt werden, beispielsweise auf der Basis von Absolutwerten der Leistungsaufnahme des Geräts 100 vor und nach deren Veränderung im Schritt 235.

In Abhängigkeit des Ergebnisses des Vergleichs in Schritt 256 wird in Schritt 270 ein Signal ausgegeben, welches das Ergebnis der Überprüfung der elektrischen Verbindung 115 widerspiegelt. Bei einer Ausführungsform ist dies ein elektrisches Signal. In einer anderen Ausführungsform handelt es sich um eine Nachricht, die beispielsweise über die Kommunikationsverbindung 130 an das Steuergerät 125 übermittelt wird. In noch einer weiterem Ausführungsform handelt es sich um ein optisches, akustisches oder haptisches Signal, welches beispielsweise mittels der Schnittstelle 180 an eine Bedienperson, insbesondere einen Fahrer des Kraftfahrzeugs 105, ausgegeben wird.

## Patentansprüche

1. Elektrisches Gerät (100), umfassend:
- Anschlüsse (110) für eine elektrischen Verbindung (115) zu einer Spannungsquelle (182, 184);
- eine Abtasteinrichtung (165) zur Bestimmung einer an den Anschlüssen (110) anliegenden Spannung;
- eine steuerbare Last (150) zur Veränderung einer elektrischen Leistungsaufnahme des Geräts (100) an den Anschlüssen (110); und
- eine Steuereinrichtung (165), die dazu eingerichtet ist, eine Degradation der elektrischen Verbindung (115) zu bestimmen, falls bei unterschiedlichen elektrischen Leistungsaufnahmen an den Anschlüssen (110) anliegende Spannungen sich um mehr als ein vorbestimmtes Maß voneinander unterscheiden.

2. Gerät (100) nach Anspruch 1, wobei die elektrische Verbindung (115) eine Steckverbindung (186) und die Degradation eine Korrosion der Steckverbindung (186) umfasst.

3. Gerät (100) nach einem der vorangehenden Ansprüche, wobei die elektrische Verbindung (115) ein elektromechanisches Unterbrechungselement (188) und die Degradation einen Verschleiß des Unterbrechungselements (188) umfasst.

4. Gerät (100) nach einem der vorangehenden Ansprüche, wobei die steuerbare Last einen schaltbaren elektrischen Widerstand (150) umfasst.

5. Gerät (100) nach Anspruch 4, wobei das Gerät (100) ein Radarsensor zur Verwendung an einem Kraftfahrzeug (105) ist und der elektrische Widerstand eine heizbare Radarlinse (150) des Radarsensors umfasst.

6. Verfahren (200) zur Erfassung einer Degradation einer elektrischen Verbindung (115) zwischen einer Spannungsquelle (182, 184) und Anschlüssen (110) eines elektrischen Geräts (100), folgende Schritte umfassend:
- Bestimmen (220) einer ersten Spannung, die an den Anschlüssen (110) des elektrischen Geräts (100) anliegt;
- Verändern (235) einer elektrischen Leistungsaufnahme des Geräts (100) an den Anschlüssen (110);
- Bestimmen (240) einer zweiten Spannung, die an den Anschlüssen (110) des elektrischen Geräts (100) anliegt; und
- Bestimmen (265) der Degradation, falls sich die Spannungen um mehr als ein vorbestimmtes Maß voneinander unterscheiden.

7. Verfahren (200) nach Anspruch 6, wobei die Spannungen in eine digitale Form umgewandelt (225, 250) und in der digitalen Form miteinander verglichen (260) werden.

8. Verfahren (200) nach einem der vorangehenden Ansprüche, ferner umfassend ein Empfangen (205) eines das Verfahren (200) auslösenden Signals von einem mit dem Gerät (100) verbindbaren Steuergerät (125).

9. Verfahren (200) nach Anspruch 8, ferner umfassend den Schritt des Ausgebens (270) eines auf die Degradation hinweisenden Signals an ein weiteres Steuergerät (125).

10. Computerprogrammprodukt mit Programmcodemitteln zur Durchführung des Verfahrens (200) nach einem der Ansprüche 6 bis 9, wenn es auf einer Verarbeitungseinrichtung (160) abläuft oder auf einem computerlesbaren Datenträger gespeichert ist.
